# EUROPÄISCHE PATENTSCHRIFT

(11) **EP 1 676 330 B1**
(45) Veröffentlichungstag und Bekanntmachung des Hinweises auf die Patenterteilung: **26.05.2010**
(21) Anmeldenummer: 04790008.9
(22) Anmeldetag: 19.10.2004
(51) Int. Cl.: H01L 51/00, C09J 7/02

(54) **STRUKTURIERUNG VON ELEKTRISCHEN FUNKTIONSSCHICHTEN MITTELS EINER TRANSFERFOLIE UND STRUKTURIERUNG DES KLEBERS**
STRUCTURING OF ELECTRICAL FUNCTIONAL LAYERS BY MEANS OF A TRANSFER FILM AND STRUCTURING THE ADHESIVE
Méthode pour structurer des couches fonctionelles electriques au moyen d'un film de transfer et méthode pour structurer l'adhesif

(30) Priorität: 24.10.2003 DE 10349963
(43) Veröffentlichungstag der Anmeldung: 05.07.2006
(73) Patentinhaber: Leonhard Kurz Stiftung & Co. KG, 90763 Fürth (DE)
(72) Erfinder: WILD, Heinrich, 91074 Herzogenaurach (DE); BREHM, Ludwig, 91325 Adelsdorf (DE); HANSEN, Achim, CH-6300 Zug (CH)
(74) Vertreter: Zinsinger, Norbert
(86) Internationale Anmeldenummer: PCT/DE2004/002319
(87) Internationale Veröffentlichungsnummer: WO 2005/039868

(56) Entgegenhaltungen:
- EP-A- 1 041 620
- WO-A1-99/49525
- WO-A2-02/070271
- FUJITA KATSUHIKO ET AL: "Flexible organic field-effect transistors fabricated by the electrode-peeling transfer with an assist of self-assembled monolayer" APPLIED PHYSICS LETTERS, AMERICAN INSTITUTE OF PHYSICS. NEW YORK, US, Bd. 82, Nr. 24, 16. Juni 2003 (2003-06-16), Seiten 4373-4375, XP012034409 ISSN: 0003-6951

## Beschreibung

Die Erfindung betrifft ein Verfahren zur Herstellung einer Folie mit zumindest einem elektrischen Bauelement, insbesondere in organischer Halbleiter-Technologie.

Zur Herstellung von elektrischen Bauelementen in organischer Halbleiter-Technologie, beispielsweise von organischen Feldeffekt-Transistoren (OFETs) oder anderen elektrischen Bauelementen aus organischen Polymeren, ist eine Strukturierung zumindest der leitfähigen Elektrodenschicht erforderlich. Eine Strukturierung der anderen Schichten solcher Bauelemente ist nicht unbedingt erforderlich, kann aber die Leistungsfähigkeit solcher Bauelemente in organischer Halbleiter-Technologie verbessern. Um leistungsfähige elektrische Bauelemente in organischer Halbleiter-Technologie herstellen zu können, ist es hierbei erforderlich, die Strukturierung der Schichten mit hoher Auflösung und Registergenauigkeit durchzuführen.

WO 02/25750 beschreibt die Herstellung von Elektroden oder Leiterplatten mit einem Lithographie-Verfahren. Hierbei wird eine leitfähige organische Schicht aus dotiertem Polyanilin (PANI) oder Polyethylendioxthiophen (PEDOT) durch Rakeln, Aufsprühen, Spin-Coating oder Siebdruck flächig auf ein Substrat, beispielsweise eine Folie, aufgebracht. Hierauf wird eine dünne Schicht aus Photoresist aufgebracht und strukturiert belichtet. Bei der Entwicklung wird die frei gelegte Polyanilin-Schicht durch Einwirkung des Entwicklers deprotiniert und damit nicht leitend. Mit einem Lösemittel wird der verbleibende Photoresist gelöst. Vor oder nach diesem Schritt wird die nicht leitfähige Matrix der organischen Schicht mit einem nicht basischen Lösungsmittel herausgelöst.

WO 02/25750 beschreibt, dass auf eine flächige Funktionspolymer-Schicht eine chemische Verbindung, die deprotonierend wirkt, zur Strukturierung aufgedruckt wird. Die Verbindung ist bevorzugt eine Base. Durch eine anschliessende Spülung werden nicht leitende Bereiche selektiv entfernt.

WO 02/47183 schlägt für die Strukturierung von Schichten eines organischen Feldeffekt-Transistors vor, Funktionspolymere in Vertiefungen einer Formschicht einzubringen. Die Formschicht besteht aus einem anderen organischen Material mit isolierenden Eigenschaften, in das ein Stempel eingedrückt wird. In diese Vertiefungen wird dann das Funktionspolymer hinein gerakelt. Mit diesem Verfahren können somit extrem feine Strukturen mit lateralen Abmessungen im Bereich von 2 bis 5 µm erzeugt werden. Die Rakel-Methode ist zudem nicht materialspezifisch, d.h. zur Strukturierung aller Schichten eines organischen Feldeffekt-Transistors geeignet. Ausserdem ist die Viskositätsspanne für das Rakel ungleich grösser als für das Drucken, so dass die Funktionspolymere weitgehend in ihrer Konsistenz belassen werden können. Weiter können relativ dicke Schichten im Bereich bis 1 µm erzeugt werden.

DE 100 33 112 beschreibt ein Verfahren zur Herstellung von elektrischen Bauelementen in organischer Halbleiter-Technologie, bei dem Funktionspolymere mittels eines Tampon-Druckverfahrens auf ein Substrat oder eine bereits vorhandene Schicht aufgebracht werden.

Die WO 02/070271 A2 beschreibt ein Thermotransfer-Verfahren zur Strukturierung organischer Funktionsschichten, bei dem eine Heizschicht eingesetzt wird.

Die Veröffentlichung XP 007904898, "Photopolymerization of Butyl Methacrylate in the Presence of Nanoparticles of ZnO, sensitized to visible light with Xanthene Dyes", A. L. Stroyuk et al., Theoretical and Experimental Chemistry, Vol. 38, Nr. 5, 2002, beschreibt die Steigerung der UV-Sensibilität von Butylmethacrylat durch Zugabe von weiteren Stoffen.

Der Erfindung liegt nun die Aufgabe zugrunde, die Herstellung leistungsfähiger Bauelement in organischer Halbleiter-Technologie zu verbessern und/oder den Aufbau verbesserter Bauelemente in organischer Halbleiter-Technologie anzugeben.

Diese Aufgabe wird durch ein Verfahren zur Herstellung einer Folie mit zumindest einem elektrischen Bauelement insbesondere in organischer Halbleiter-Technologie gelöst, bei dem auf eine Grundfolie eine Kleberschicht aus einem Strahlungs-vernetzbaren Kleber aufgebracht wird, wobei die Kleberschicht aus dem Strahlungs-vernetzbaren Kleber in musterförmig strukturierter Form auf die Grundfolie aufgebracht wird und/oder derart musterförmig bestrahlt wird (beispielsweise mit UV-Strahlung), dass die Kleberschicht musterförmig strukturiert aushärtet, wobei eine Transferfolie, die eine Trägerfolie und eine elektrische Funktionsschicht aufweist, mit einer Orientierung der elektrischen Funktionsschicht zur Kleberschicht auf die Kleberschicht aufgebracht wird und die Trägerfolie von dem die Grundfolie, die Kleberschicht und die elektrische Funktionsschicht umfassenden Folienkörper abgezogen wird, wodurch in einem ersten musterförmig strukturieren Bereich die elektrische Funktionsschicht als Teil des elektrischen Bauelements auf der Kleberschicht und der Grundfolie verbleibt und in einem zweiten musterförmig strukturieren Bereich die elektrische Funktionsschicht auf der Trägerfolie verbleibt und mit der Trägerfolie von der Grundfolie abgezogen wird.

Gemäß eines ersten erfindungsgemäßen Verfahrens wird die Kleberschicht aus dem Strahlungs-vernetzbaren Kleber nach dem Aufbringen der Transferfolie musterförmig bestrahlt, wodurch die Kleberschicht in einem musterförmig strukturierten Bereich aushärtet, und die Trägerfolie von dem die Grundfolie, die Kleberschicht und die elektrische Funktionsschicht umfassenden Folienkörper abgezogen, so dass die elektrische Funktionsschicht in dem musterförmig strukturierten ersten Bereich, in dem die Kleberschicht ausgehärtet ist, auf der Grundfolie verbleibt, und in dem zweiten Bereich, in dem die Kleberschicht nicht ausgehärtet ist, mit der Trägerfolie abgezogen wird.

Gemäß eines zweiten erfindungsgemäßen Verfahrens wird die Kleberschicht aus dem Strahlungs-vernetzbaren Kleber vor dem Aufbringen der Transferfolie derart musterförmig bestrahlt, dass die Kleberschicht in einem musterförmig strukturierten Bereich aushärtet. Die Transferfolie wird auf die musterförmig strukturierte ausgehärtete Kleberschicht aufgebracht und die Trägerfolie von dem die Grundfolie, die Kleberschicht und die elektrische Funktionsschicht umfassenden Folienkörper abgezogen, so dass die elektrische Funktionsschicht in dem musterförmig strukturierten ersten Bereich, in dem die Kleberschicht nicht ausgehärtet ist, auf der Grundfolie verbleibt, und in dem musterförmig strukturierten zweiten Bereich, in dem die Kleberschicht ausgehärtet ist, mit der Trägerfolie abgezogen wird.

Es wird eine Folie mit zumindest einem elektrischen Bauelement, insbesondere in organischer Halbleiter-Technologie, gebildet, die eine Kleberschicht aus einem Strahlungs-vernetzbaren Kleber aufweist, die zwischen einer musterförmig strukturierten elektrischen Funktionsschicht und einem Folienkörper der Folie angeordnet ist und die musterförmig strukturierte elektrische Funktionsschicht mit dem Folienkörper verbindet.

Die Aufgabe wird weiter von einem nicht erfindungsgemäßen Verfahren zur Herstellung einer Folie mit mindestens einem elektrischen Bauelement insbesondere in organischer Halbleiter-Technologie gelöst, bei dem auf eine Grundfolie ein Strahlungs-vernetzbarer Waschlack in musterförmig strukturierter Form aufgebracht wird, die musterförmig strukturierte Waschlackschicht bestrahlt (z.B. mit UV-Licht) wird, so dass die Waschlackschicht aushärtet, auf die Waschlackschicht eine elektrische Funktionsschicht aufgebracht wird und in einem Waschprozess die musterförmig strukturierte Waschlackschicht mit dem darüber liegenden Bereich der elektrischen Funktionsschicht entfernt wird, so dass die elektrische Funktionsschicht auf dem Grundkörper in dem musterförmig strukturierten Bereich verbleibt, auf den keine Waschlackschicht aufgebracht worden ist.

Durch die Erfindung wird es möglich, elektrische Funktionsschichten eines Bauelements in organischer Halbleiter-Technologie registergenau und mit hoher Auflösung zu strukturieren. So ist es beispielsweise möglich, Abstände zwischen einer Source- und einer Drain-Elektrode eines organischen Feldeffekt-Transistors zu erzielen, die geringer als 25 µm sind. Weitere Vorteile der Erfindung bestehen darin, dass dieses Verfahren sehr kostengünstig und für den grossindustriellen Einsatz geeignet ist. So ist es durch den Einsatz von lithographischen Verfahren zwar möglich, hohe Auflösungen zu erzielen. Lithographische Verfahren erfordern andererseits jedoch die Durchführung einer Vielzahl von Verfahrensschritten und den Einsatz von hochwertigen und teueren Hilfsstoffen: Das Substrat muss beschichtet, maskiert, belichtet, entwickelt, geätzt und gestrippt werden. Weiter wird beim Einsatz des erfindungsgemässen Verfahrens eine Verbesserung der Qualität der generierten elektrischen Bauelemente in organischer Halbleiter-Technologie erzielt: Bei dem erfindungsgemässen Verfahren handelt es sich um ein trockenes Verfahren, durch das eine Verunreinigung von halbleitenden Schichten weitgehend vermieden wird. Die halbleitenden Schichten eines elektrischen Bauelements in organischer Halbleiter-Technologie sind extrem empfindlich gegenüber Verunreinigungen, da diese, beispielsweise durch die protonierende Wirkung, bereits in geringen Konzentrationen die elektrischen Eigenschaften von halbleitenden Schichten verändern können. So ist es beispielsweise bei einem lithographischen Verfahren kaum vermeidbar, dass organische halbleitende Schichten durch die notwendigen Entwicklungs-, Ätz- und Stripp-Prozesse verunreinigt werden. Weiter hat sich gezeigt, dass sich beim direkten Verdrucken von leitfähigen Polymeren die erforderliche hochauflösende Strukturierung von elektrischen Funktionsschichten, insbesondere unter dem Gesichtspunkt einer ausreichenden Reproduzierbarkeit, nur mit sehr hohem Aufwand erzielen lassen. Dies liegt vor allem an der Viskosität der zur Verfügung stehenden Druckstoffe, die eine Verdruckung in ausreichender Dicke und Reproduzierbarkeit, insbesondere mit grosstechisch verfügbaren Drucktechniken, behindert. Weiter wird durch die Erfindung eine thermische Belastung von halbleitenden Schichten während des Herstellungsprozesses vermieden.

Durch die Erfindung wird somit ein kostengünstiges, grossindustriell anwendbares Herstellungsverfahren für Folien mit elektrischen Bauelementen in organischer Halbleiter-Technologie angegeben, das hohe qualitative Anforderungen erfüllt.

Vorteilhafte Ausgestaltungen der Erfindung sind in den Unteransprüchen bezeichnet.

Gemäss eines bevorzugten Ausführungsbeispieles der Erfindung wird die Kleberschicht mittels eines Druckverfahrens musterförmig strukturiert auf die Grundfolie aufgedruckt, die Transferfolie auf die Kleberschicht aufgebracht, die Kleberschicht durch Bestrahlung mit Strahlung ausgehärtet und so dann die Trägerfolie von dem aus Grundfolie, Kleberschicht und elektrischer Funktionsschicht gebildeten Folienkörper abgezogen. Damit verbleibt die elektrische Funktionsschicht in den Bereichen, die mit dem Strahlungs-vernetzbaren Kleber bedruckt sind. Vorteilhaft ist hier, dass aufgrund der sich unterscheidenden Eigenschaften der Drucksubstanz und der sich unterscheidenden zu erzielenden Schichtdicken sich höhere Auflösungen als bei dem direkten Verdrucken von leitfähigen Polymeren erzielen lassen. Weiterhin ist es möglich, kostengünstige und grossindustriell anwendbare Drucktechniken wie Tiefdruck, Offset-Druck und Flexo-Druck verwenden zu können.

Gemäss eines weiteren bevorzugten Ausführungsbeispieles der Erfindung wird der UV-vernetzbare Kleber vollflächig auf die Grundfolie aufgebracht und so dann musterförmig mit UV-Licht belichtet, so dass die Kleberschicht in einem musterförmig strukturierten Bereich aushärtet. Dann wird die Transferfolie auf die Kleberschicht aufgebracht. Anschliessend wird die Trägerfolie von dem aus Grundfolie, Kleberschicht und elektrischer Funktionsschicht gebildeten Folienkörper abgezogen. Hierbei verbleibt die elektrische Funktionsschicht in den musterförmig strukturierten Bereichen, in denen die Kleberschicht nicht ausgehärtet ist und noch über eine gewisse Klebrigkeit verfügt, auf der Grundfolie. In dem übrigen Bereich, d.h. in dem Bereich, in dem die Kleberschicht ausgehärtet ist, verbleibt die elektrische Funktionsschicht auf der Trägerfolie und wird mit der Trägerfolie abgezogen. Durch ein derartiges Vorgehen lassen sich strukturierte elektrische Funktionsschichten in sehr hoher Auflösung auf der Grundfolie erzeugen. Weiter ergeben sich hier Kostenvorteile, da beispielsweise der Einsatz hochwertiger Tiefdruck-Rasterwalzen nicht notwendig ist.

Um eine ausreichende Belichtung der Kleberschicht bei den oben beschriebenen Verfahren sicherzustellen, ist es vorteilhaft, die elektrische Funktionsschicht aus einem semi-transparenten Material, beispielsweise einer sehr dünnen Metallschicht, zu bilden und eine Strahlungs-durchlässige Trägerfolie zu verwenden. Hierdurch wird es möglich, die Kleberschicht von Seiten der Transferfolie durch die Transferfolie hindurch zu bestrahlen. Alternativ besteht die Möglichkeit, die Grundfolie Strahlungs-transparent auszugestalten und die Kleberschicht von Seiten der Grundfolie durch die Grundfolie hindurch zu belichten.

Gemäss einer Ausführungsform der Erfindung wird die Kleberschicht nach dem Aufbringen der Transferfolie musterförmig belichtet, so dass die Kleberschicht in einem musterförmig strukturierten Bereich aushärtet. Anschliessend wird die Trägerfolie von dem aus Grundfolie und elektrischer Funktionsschicht gebildeten Folienkörper abgezogen. In dem Bereich, in dem die Kleberschicht musterförmig strukturiert ausgehärtet ist, wird die elektrische Funktionsschicht von der Kleberschicht fixiert und verbleibt auf dem Grundkörper. In dem übrigen Bereich, in dem die Kleberschicht nicht ausgehärtet ist, verbleibt die elektrische Funktionsschicht auf der Transferfolie und wird mit der Trägerfolie abgezogen. Hierbei ist es notwendig, einen Strahlungs-verrietzbaren Kleber zu verwenden, der im nicht ausgehärteten Zustand eine geringere Adhäsionskraft gegenüber der elektrischen Funktionsschicht als die Adhäsionskraft zwischen elektrischer Funktionsschicht und der Trägerfolie besitzt.

Der Vorteil dieser Vorgehensweise besteht darin, dass elektrische Funktionsschichten in sehr hoher Auflösung auf der Grundfolie erzeugt werden können und dass keine einschränkenden Bedingungen bezüglich der Strahlungs-Transparenz der elektrischen Funktionsschicht und des Grundkörpers bestehen.

Der Einsatz des Verfahrens im Rahmen eines grossindustriellen Rolle-zu-Rolle-Prozesses wird durch die Verwendung eines Trommel-Belichters oder eines Masken-Belichters mit einem umlaufenden Maskenband für die musterförmige Bestrahlung der Kleberschicht mit UV-Licht ermöglicht.

Von besonderer Bedeutung für das erfindungsgemässe Verfahren ist die Verwendung einer geeigneten Transferfolie, die eine schnelle und präzise Ablösung der elektrischen Funktionsschicht von der Trägerfolie ermöglicht. Hierbei hat es sich insbesondere als zweckmässig herausgestellt, zwischen Trägerfolie und elektrischer Funktionsschicht eine Ablöseschicht vorzusehen.

Die elektrische Funktionsschicht kann eine elektrisch leitfähige Schicht sein. Eine besonders präzise Durchtrennung der elektrischen Funktionsschicht am Übergang von Bereichen, die auf der einen Seite auf der Grundfolie und auf der anderen Seite auf der Trägerfolie verbleiben, wird durch den Einsatz von elektrischen Funktionsschichten erzielt, die leitfähige Partikel, vorzugsweise Nano-Partikel, beispielsweise Metall-, Russ- oder Graphit-Partikel, enthalten. Hierbei hat es sich gezeigt, dass insbesondere Funktionsschichten bestehend auf leitfähigen Nano-Partikeln und Bindemittel, insbesondere bei einem geringen Bindemittelanteil, eine präzise Durchtrennung ermöglichen. Weiter hat es sich als vorteilhaft gezeigt, die elektrische Funktionsschicht beim Aufbringen auf die Grundfolie zu komprimieren, wodurch sich die elektrische Leitfähigkeit durch die Verpressung der Nano-Partikel erhöht.

Eine hohe Präzision der Durchtrennung lässt sich auch durch den Einsatz von dünnen Metallschichten oder Dünnschichten aus Metall-Legierungen als elektrische Funktionsschichten erzielen. Weiter ist der Einsatz von elektrischen Funktionsschichten aus leitfähigen Polymeren oder anorganisch leitfähigen Schichten, wie z.B. ITO, zweckmässig.

Je nach Aufbau des Bauelementes in organischer Halbleiter-Technologie lassen sich durch den Einsatz von elektrisch nicht leitenden oder elektrisch leitenden Klebstoffen für die Kleberschicht Verfahrensschritte beim Aufbau des elektrischen Bauelements einsparen. Die elektrische Funktionsschicht erbringt hierbei innerhalb des elektrischen Bauelements vorzugsweise die Funktion einer mikrostrukturierten Elektrodenschicht, die eine oder mehrere Elektroden des elektrischen Bauelements ausbildet, oder die Funktion einer mikrostrukturierten Halbleiter-Schicht, die ein oder mehrere halbleitende Komponenten des elektrischen Bauelements ausbildet.

Für eine nach einem erfindungsgemäßen Verfahren gebildete Folie hat es sich bewährt, wenn die Kleberschicht aus einem Strahlungs-vernetzbaren Kleber in gleicher Weise wie die musterförmig strukturierte elektrische Funktionsschicht musterförmig strukturiert ist.
Die elektrische Funktionsschicht der Folie ist insbesondere eine mikrostrukturierte Elektrodenschicht, die eine oder mehrere Elektroden des elektrischen Bauelements ausbildet, oder eine mikrostrukturierte Halbleiterschicht, die eine oder mehrere halbleitende Komponenten des elektrischen Bauelements ausbildet.
Besonders bevorzugt ist es, wenn das elektrische Bauelement ein organischer Feldeffekttransistor ist.

Im folgenden wird die Erfindung anhand von mehreren Ausführungsbeispielen unter Zuhilfenahme der beiliegenden Zeichnungen beispielhaft erläutert.
Fig. 1 zeigt eine funktionelle Darstellung eines Verfahrens-Ablaufs gemäss eines ersten Ausführungsbeispieles der Erfindung.
Fig. 2 zeigt eine funktionelle Darstellung eines Verfahrens-Ablaufs gemäss eines weiteren Ausführungsbeispieles der Erfindung.
Fig. 3 zeigt eine funktionelle Darstellung eines Verfahrens-Ablaufs gemäss eines weiteren Ausführungsbeispieles der Erfindung.
Fig. 4a bis Fig. 4d zeigen Schnitt-Darstellungen von Folienkörpern für den VerfahrensAblauf nach Fig. 1.
Fig. 5a bis Fig. 5e zeigen Schnitt-Darstellungen von Folienkörpern zur Verdeutlichung eines weiteren Ausführungsbeispieles der Erfindung.

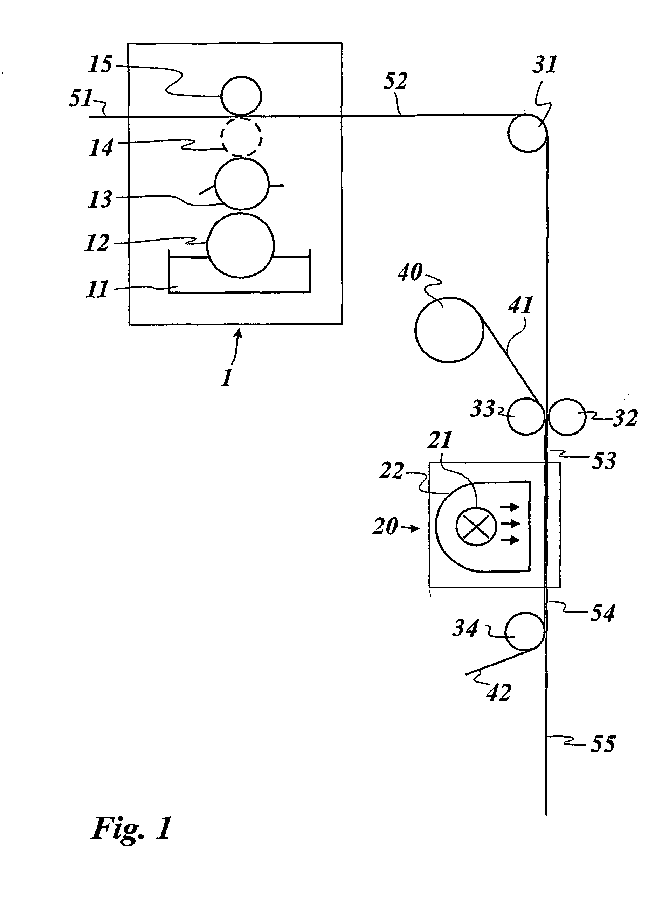

Fig. 1 skizziert einen Ausschnitt aus einem Rolle-zu-Rolle-Fertigungs-Prozess mittels dem eine Folie mit zumindest einem elektrischen Bauelement in organischer Halbleiter-Technologie hergestellt wird.

Unter elektrischen Bauelementen in organischer Halbleiter-Technologie werden hierbei elektrische Bauelemente verstanden, die zumindest eine Schicht aus einem organischen Halbleiter-Material umfassen. Organische Halbleiter-Materialien, organische leitfähige Materialien und organische Isolations-Materialien werden hierbei von organischen, metall-organischen und/oder anorganischen Substanzen gebildet, die die jeweiligen elektrischen Eigenschaften besitzen. Als Funktions-Polymere werden hierbei solche organischen, metall-organischen und/oder anorganischen Materialien bezeichnet, die bei dem Aufbau von Bauelementen in organischer Halbleiter-Technologie Verwendung finden können. Der Begriff Funktions-Polymer umfasst demnach auch nicht-polymere Komponenten. Bauelemente, die eine organische Halbleiter-Schicht oder Halbleiter-Schichtbereiche als funktionelle Komponente umfassen, sind beispielsweise Transistoren, FETs, Triacs, Dioden, usw.. Als organisches Halbleiter-Material kann hier beispielsweise Polythiophen Verwendung finden.

Fig. 1 zeigt nun eine Druckstation 1, eine Belichtungsstation 20, eine Umlenkrolle 31 und drei Walzen 32, 33 und 34. Eine Grundfolie 51 wird der Druckstation 1 zugeführt. Die von der Druckstation 10 bearbeitete Grundfolie 51 wird als Folie 52 über die Umlenkrolle 31 dem Walzenpaar 32 und 33 zugeführt, das auf die Folie 52 eine von einer Transferfolien-Rolle 40 abgerollte Transferfolie 41 aufbringt. Hierdurch ergibt sich die Folie 53. Die von der Belichtungsstation 20 bearbeitete Folie 53 wird als Folie 54 der Walze 34 zugeführt, wo eine Trägerfolie 42 von der Folie 54 abgezogen und als Rest-Folie eine Folie 55 verbleibt.

Bei der Grundfolie 51 kann es sich im einfachsten Fall um eine Trägerfolie handeln. Eine solche Trägerfolie besteht bevorzugt aus einer Kunststoff-Folie mit einer Stärke von 6 µm bis 200 µm, beispielsweise aus einer Polyester-Folie mit einer Stärke von 19 µm bis 38 µm. Üblicherweise wird die Grundfolie 51 jedoch neben einer derartigen Trägerfolie noch weitere, in vorangehenden Verfahrensprozessen aufgebrachte Schichten aufweisen. Derartige Schichten sind beispielsweise Lackschichten, Isolationsschichten und elektrische Funktionsschichten. So ist es möglich, dass die Grundfolie 51 bereits ein oder mehrere Funktions-Polymerschichten umfasst, beispielsweise Schichten aus organisch leitfähigen Polymeren, wie Polyanilin und Polypyrrol, halbleitende Schichten, beispielsweise aus Polythiophen, und Isolationsschichten, beispielsweise aus Polyvinylphenol. Hierbei ist es auch möglich, dass diese Schichten bereits in strukturierter Form in der Grundfolie 51 vorliegen.

Die Druckstation 1 weist eine Farbwanne mit einem UV-vernetzbaren Kleber 11 auf. Mittels mehrerer Übertragungswalzen 12 und 13 wird der Kleber 11 auf den Druckzylinder 14 aufgebracht. Der Druckzylinder 14 bedruckt nun die zwischen dem Druckzylinder 14 und einer Gegendruckwalze 15 hindurch laufende Grundfolie 51 musterförmig strukturiert mit einer Kleberschicht aus dem UV-vernetzbaren Kleber 11.

Bei der Druckstation 1 handelt es sich bevorzugt um eine Offset- oder Flexo-Druck-Druckstation. Es ist jedoch auch möglich, dass es sich bei der Druckstation 1 um eine Tiefdruck-Druckstation handelt.

Die Kleberschicht hat vorzugsweise eine Dicke von 0,5 µm bis 10 µm.

Als UV-vernetzbare Kleber 11 können bevorzugt folgende Kleber verwendet werden:
Foilbond UVH 0002 von AKZO NOBEL INKS und UVAFLEX UV Adhesive VL000ZA von Zeller + Gmelin GmbH.
Bevorzugt werden die Kleber mit einem Auftraggewicht von 1 g/m2 - 5 g/m2 auf die Grundfolie 51 aufgebracht.

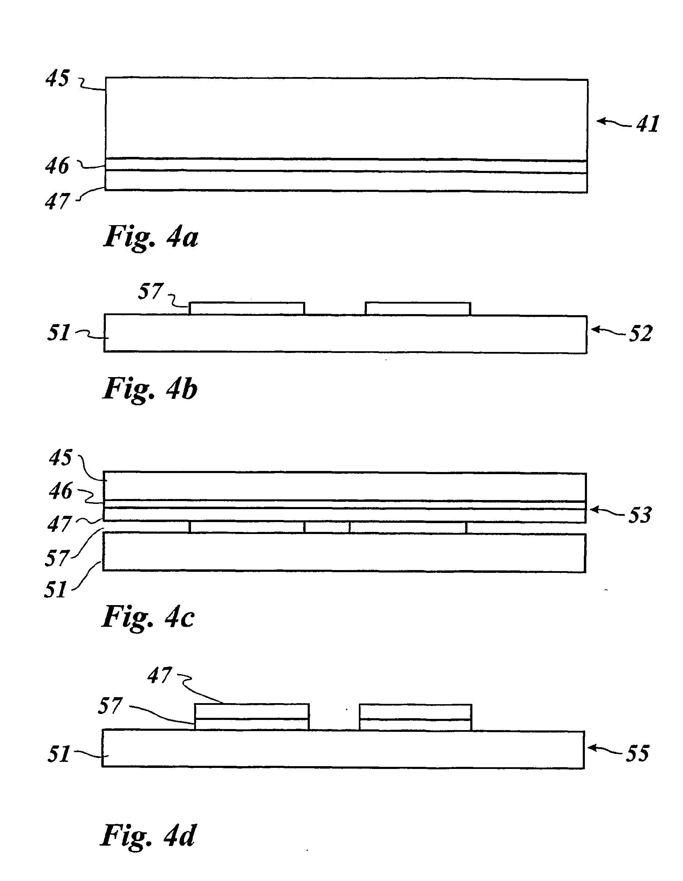

Durch das Bedrucken ergibt sich so die in Fig. 4b dargestellte Folie 52, bei der auf dem Grundkörper 51 eine musterförmig strukturierte Kleberschicht 57 aufgebracht ist.

Je nach Art des verwendeten Klebers 11 ist es hierbei auch möglich, dass die Folie 52 einen Trockenkanal durchläuft, in dem die Kleberschicht 57 beispielsweise bei einer Temperatur von 100 bis 120 °C getrocknet wird.

Fig. 4a zeigt den Aufbau der Transferfolie 41. Die Transferfolie 41 weist eine Trägerfolie 45, eine Ablöseschicht 46 und eine elektrische Funktionsschicht 47 auf.

Bei der Trägerfolie 45 handelt es sich um eine Kunststoff-Folie einer Dicke von 4 bis 75 µm. Vorzugsweise handelt es sich bei der Trägerfolie 45 um eine Folie aus Polyester, Polyethylen, einem Acrylat oder einem geschäumten Verbundstoff. Die Dicke der Trägerfolie 45 beträgt bevorzugt 12 µm.

Die Ablöseschicht 46 besteht bevorzugt aus einem Wachstyp. Auf die Ablöseschicht 46 kann auch verzichtet werden, wenn die Materialien der Trägerfolie 45 und der elektrischen Funktionsschicht 47 derart gewählt sind, dass die Adhäsionskräfte zwischen der elektrischen Funktionsschicht 47 und der Trägerfolie 45 ein sicheres und schnelles Ablösen der elektrischen Funktionsschicht 47 nicht behindern.

Die Ablöseschicht 46 kann beispielsweise nach folgender Rezeptur hergestellt sein:

| | |
|---|---|
| Ablöseschicht 46 (Trennschicht) | |
| Toluol | 99,5 Teile |
| Esterwachs (Tropfpunkt 90 °C) | 0,5 Teile |

Vorzugsweise wird die Ablöseschicht 46 in einer Dicke von 0,01 bis 0,2 µm auf die Trägerfolie 45 aufgebracht.

Je nach der Funktion, die die elektrische Funktionsschicht innerhalb des herzustellenden elektrischen Bauelements erbringen soll, setzt sich die elektrische Funktionsschicht 47 aus elektrisch leitfähigen oder halbleitenden Materialien zusammen. Für den Fall, dass die elektrische Funktionsschicht 47 eine elektrisch leitfähige Funktionsschicht bilden soll, bestehen folgende Möglichkeiten der Ausgestaltung der elektrischen Funktionsschicht 47:
Zum einen ist es möglich, dass die elektrische Funktionsschicht 47 von einer dünnen Metallschicht gebildet wird, mit der der aus Trägerfolie 45 und Ablöseschicht 46 bestehende Folienkörper beispielsweise durch Bedampfung beschichtet wird. Die Dicke einer derartigen dünnen Metallschicht liegt vorzugsweise im Bereich von 5 nm bis 50 nm, um eine ausreichend hochauflösende Strukturierbarkeit der elektrischen Funktionsschicht mittels des erfindungsgemässen Verfahrens sicherzustellen. Die Metallschicht kann hier beispielsweise aus Aluminium, Silber, Kupfer, Gold, Chrom, Nickel oder aus Legierungen mit diesen Metallen bestehen.

Besonders gute Ergebnisse lassen sich erzielen, wenn als elektrische Funktionsschicht 47 eine Schicht aus leitfähigen Nano-Partikeln aufgebracht wird.
Die elektrische Funktionsschicht 47 hat beispielsweise eine Dicke von 50 nm bis 1 µm und setzt sich aus leitfähigen Nano-Partikeln und Bindemittel zusammen, wobei der Bindemittel-Anteil gering gehalten ist, um ein präzises Trennen der Schicht 47 zu gewährleisten. Die Dicke der elektrischen Funktionsschicht 47 wird hierbei auch wesentlich durch die von der elektrischen Funktionsschicht 47 im Rahmen des elektrischen Bauelements geforderten elektrischen Eigenschaften, beispielsweise spezifischer Widerstand, bestimmt. Hierbei ist es auch möglich, dass die Leitfähigkeit der Schicht 47 erst bei Auftrag der Transferfolie 41 auf die Folie 52 den gewünschten Wert erreicht. Durch den bei diesem Auftrag ausgeübten Druck auf die elektrische Funktionsschicht 47 wird die elektrische Funktionsschicht 47 komprimiert, wodurch sich die Abstände zwischen den elektrisch leitfähigen Nano-Partikeln verringert und die elektrische Leitfähigkeit der Schicht 47 erheblich erhöht wird.

Weiter ist es auch möglich, als elektrische Funktionsschicht 47 eine Schicht aus sonstigen leitfähigen Materialien, beispielsweise aus ITO-Materialien (ITO = Indium Zinn Oxide), oder aus anderen transparenten leitfähigen Oxiden, beispielsweise aluminiumdotiertes Zinkoxid oder aus elektrisch leitfähigen Polymeren, beispielsweise Polyanilin und Polypyrrol, zu verwenden.

Weiterhin ist es auch möglich, dass die elektrische Funktionsschicht 47 von einem halbleitenden Material gebildet wird. Hierzu wird ein organisches Halbleiter-Material auf die Ablöseschicht 46 in flüssiger, gelöster Form oder als Suspension aufgebracht und sodann verfestigt. Die Dicke einer derartigen elektrischen Funktionsschicht 47 wird hierbei im wesentlichen durch die elektrische Funktion dieser Schicht innerhalb des herzustellenden elektrischen Bauelementes bestimmt.

Die leitfähigen Nano-Partikel werden vorzugsweise in Form einer nicht stark verdünnten Dispersion auf die Ablöseschicht 46 aufgebracht.

Fig. 4c zeigt die Folie 53, d.h. den sich nach Aufbringen der Transferfolie 41 auf die mit der musterförmig strukturierten Kleberschicht 57 bedruckten Grundfolie 51 ergebenden Folienkörper. Fig. 4c zeigt die Grundfolie 51, die Kleberschicht 57, die elektrische Funktionsschicht 47, die Ablöseschicht 46 und die Trägerfolie 45. Der Anpressdruck, mittels dem die Transferfolie 41 auf die Folie 52 mittels der Druck- und Gegendruck-Walzen 32 und 33 aufgebracht wird, ist so zu wählen, dass die musterförmige Strukturierung der Kleberschicht 57 hierdurch nicht wesentlich beeinflusst wird.

Die Belichtungsstation 20 nach Fig. 1 weist eine UV-Lampe 21 sowie einen Reflektor 22 auf, der die von der UV-Lampe 21 abgestrahlte UV-Strahlung auf die Folie 53 bündelt. Die Leistung der UV-Lampe 21 wird hierbei so gewählt, dass die Kleberschicht 57 beim Durchlaufen der Belichtungsstation 22 mit einer ausreichenden Energiemenge bestrahlt wird, die eine sichere Aushärtung der Kleberschicht 57 gewährleistet. Wie in Fig. 1 gezeigt, wird die Folie 53 hierbei von Seiten der Trägerfolie 45 bestrahlt. Dies ist möglich, wenn als elektrische Funktionsschicht 47 eine transparente oder semi-transparente Schicht verwendet wird, beispielsweise eine, wie oben ausgeführt ausgestaltete, dünne Metallschicht. Weiter ist hierfür erforderlich, dass die Trägerfolie 45 sowie die Ablöseschicht 46 aus einem UV-transparenten Material bestehen. Sollte es aufgrund der speziellen Zusammensetzung der elektrischen Funktionsschicht 47 nicht möglich sein, diese UV-transparent oder semi-transparent zu gestalten, so ist es möglich, die Folie 53 von Seiten der Grundfolie 51 mit UV-Licht zu bestrahlen. In diesem Fall wäre dann die Grundfolie 51 UV-transparent auszugestalten.

Durch die Aushärtung der musterförmig strukturieren Kleberschicht 57 wird die Funktionsschicht 47 an den Stellen, an denen die Kleberschicht 57 vorgesehen ist, mit der Grundfolie 51 verklebt. Wird so im folgenden die Trägerfolie 45 von dem restlichen Folienkörper der Folie 53 abgezogen, so haftet die elektrische Funktionsschicht 47 in den Bereichen, in denen die Kleberschicht 57 aufgedruckt ist, an der Grundfolie 51 und wird so an diesen Stellen aus der Transferfolie 41 heraus gelöst. An den übrigen Stellen überwiegt die Haftung zwischen elektrischer Funktionsschicht 47 und Ablöseschicht 46, so dass hier die elektrische Funktionsschicht 47 in der Transferfolie 41 verbleibt.

Fig. 4d zeigt nun die Folie 55, d.h. den sich ergebenden Folienkörper nach Abziehen der Trägerfolie 45. Fig. 4d zeigt die Grundfolie 51, die Kleberschicht 57 und die elektrische Funktionsschicht 47. Wie in Fig. 4d gezeigt, verfügt die Folie 55 nun über eine musterförmig strukturierte elektrische Funktionsschicht 47, die gemäss der musterförmig strukturierten Kleberschicht 57 auf der Grundfolie 51 angeordnet ist.

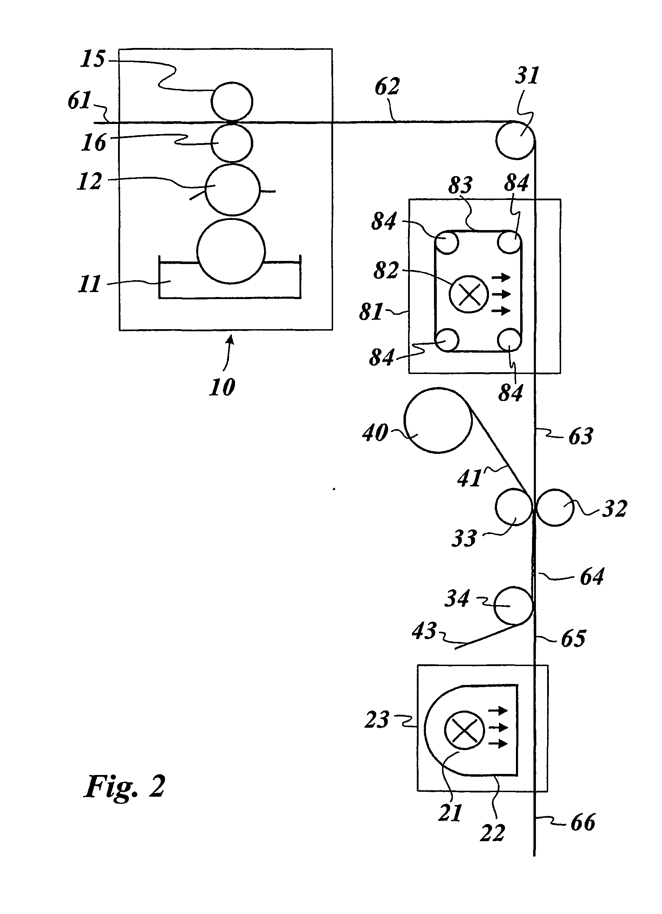

Anhand von Fig. 2 wird nun ein weiteres Ausführungsbeispiel der Erfindung erläutert.

Fig. 2 zeigt die Druckstation 10, eine Belichtungsstation 81, eine Belichtungsstation 23, die Umlenkrolle 31, die Druck- und Gegendruck-Walzen 32 und 33, die Ablösewalze 34 und die Transferfolien-Rolle 40.

Die Druckstation 10 ist wie die Druckstation 1 nach Fig. 1 aufgebaut, mit dem Unterschied, dass der Druckzylinder 14 durch einen Druckzylinder 16 ersetzt ist, der den Kleber 11 vollflächig auf eine zugeführte Grundfolie 61 aufdruckt. Hierbei ist es auch möglich, dass die Kleberschicht auf die Grundfolie 61 nicht durch ein Druckverfahren sondern durch ein anderes Beschichtungsverfahren, beispielsweise Streichen, Giessen oder Sprühen, aufgebracht wird. Weiter ist es hier auch möglich, dass der Aufdruck der Kleberschicht auf die Grundfolie 61 ebenfalls musterförmig erfolgt und damit das hier beschriebene Verfahren mit dem Verfahren nach Fig. 1 kombiniert wird.

Die Grundfolie 61 und die auf die Grundfolie aufgedruckte Kleberschicht aus einem UV-vernetzbaren Kleber sind wie die Grundfolie 51 und die Kleberschicht 57 nach Fig. 4b ausgestaltet, mit dem Unterschied, dass hier die Kleberschicht 57 bevorzugt vollflächig auf die Grundfolie 61 aufgedruckt ist. Der sich nach Auftragen der Kleberschicht auf die Grundfolie 61 ergebende Folienkörper 62 wird über die Umlenkrolle 31 der Belichtungsstation 81 zugeführt.

Vorzugsweise wird hierbei ein prepolymerer UV-vernetzbarer Kleber verwendet.

Bei der Belichtungsstation 81 handelt es sich um einen Masken-Belichter, der eine Belichtung von Rolle zu Rolle mittels eines mit der Laufgeschwindigkeit der Folie 62 synchronisierten Maskenbandes ermöglicht. Der Masken-Belichter 81 weist so mehrere Umlenkrollen 84, ein Maskenband 83 und eine UV-Lampe 82 auf. Das Maskenband 83 weist UV-transparente und opake oder reflektierende Bereiche auf. Das Maskenband bildet so eine UV-Endlosmaske, die die Folie 62 gegenüber der UV-Lampe 82 abdeckt und eine kontinuierliche, musterförmige Bestrahlung der Folie 62 mit UV-Licht ermöglicht. Die Geschwindigkeit des Maskenbandes 83 wird, wie bereits oben erläutert, mit der Geschwindigkeit der Folie 62 synchronisiert, wobei zusätzliche optische Markierungen auf der Folie 62 eine passergenaue Belichtung ermöglichen. Die Leistung der UV-Lampe 82 ist hierbei so gewählt, dass eine für die Aushärtung der Kleberschicht ausreichende UV-Energiemenge der Folie 62 beim Durchlauf durch den Masken-Belichter 81 zugeführt wird.

Vorzugsweise wird die Folie vom Masken-Belichter 81 mit kollimiertem UV-Licht bestrahlt.

Anstelle eines mit einem Maskenband arbeitenden Masken-Belichters ist es auch möglich, einen Trommel-Belichter zu verwenden, der über eine Maske in Form einer Trommel verfügt, über die die Folie 62 geführt wird.

Durch die musterförmige Bestrahlung mit UV-Licht härtet die Kleberschicht musterförmig strukturiert aus, so dass eine Folie 63 mit ausgehärteten und nicht ausgehärteten Bereichen der Kleberschicht dem Walzenpaar 32 und 33 zugeführt wird. Durch das Walzenpaar 32 und 33 wird nun die Transferfolie 41 auf die Folie 63 aufgebracht. Die Transferfolie 41 ist hierbei wie die Transferfolie nach Fig. 4a ausgeführt. Damit ergibt sich eine Folie 64, die aus der Grundfolie 61, einer partiell ausgehärteten Kleberschicht, der elektrischen Funktionsschicht 47, der Ablöseschicht 46 und der Trägerfolie 45 besteht. In den Bereichen, in denen die Kleberschicht nicht ausgehärtet ist, ist die Kleberschicht noch klebrig, so dass hier Adhäsionskräfte zwischen Kleberschicht und darüber liegender elektrischer Funktionsschicht 47 wirken. In den übrigen Bereichen, in denen die Kleberschicht ausgehärtet ist, ist dies nicht der Fall. Beim Abziehen der Trägerfolie 45 von dem restlichen Folienkörper haftet damit die elektrische Funktionsschicht 47 in den Bereichen, in denen die Kleberschicht nicht ausgehärtet ist, an dem Grundkörper 61 und wird so von der Trägerfolie 45 abgelöst. In den übrigen Bereichen bewirken die Adhäsionskräfte zwischen der Ablöseschicht 46 und der elektrischen Funktionsschicht 47, dass in diesen Bereichen die elektrische Funktionsschicht 47 nicht abgelöst wird und auf der Trägerfolie 45 verbleibt. Damit ergibt sich nach Abziehen der Trägerfolie 45 eine Folie 65 mit einer partiellen musterförmigen elektrischen Funktionsschicht 47, die über eine vollflächige Kleberschicht mit der Grundfolie 61 verbunden ist. In einer weiteren Belichtungsstation 23, die wie die Belichtungsstation 20 nach Fig. 1 ausgestaltet ist, wird nun die Kleberschicht in den noch nicht ausgehärteten Bereichen vollständig ausgehärtet, um eine sichere Verbindung zwischen elektrischer Funktionsschicht 47 und Grundfolie 61 zu gewährleisten. Auf die Belichtungsstation 23 könnte aber auch verzichtet werden.

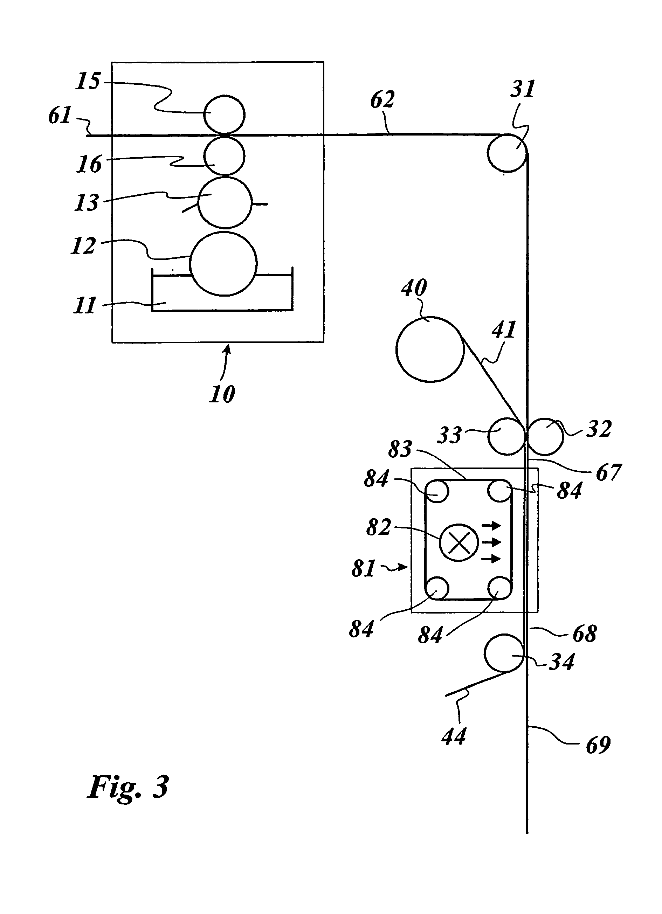

Anhand von Fig. 3 wird nun ein weiteres Ausführungsbeispiel der Erfindung erläutert.

Fig. 3 zeigt die Druckstation 10, die Belichtungsstation 81, die Umlenkrolle 31, die Druck- und Gegendruck-Walzen 32 und 33, die Ablösewalze 34 und die Transferfolien-Rolle 40.

Der Druckstation 10 wird die Grundfolie 61 zugeführt, die wie nach Fig. 2 mit einer Kleberschicht beschichtet wird, wodurch sich die Folie 62 nach Fig. 2 ergibt. Auf die Folie 62 wird nun durch das Walzenpaar 32 und 33 die Transferfolie 41 aufgebracht. Die Transferfolie 41 ist hierbei nach Fig. 4a ausgestaltet. Es ergibt sich damit eine Folie 67, die aus der Grundfolie 61, einer vollflächigen, nicht ausgehärteten Kleberschicht, der elektrischen Funktionsschicht 47, der Ablöseschicht 46 und der Trägerfolie 45 besteht.

Die Folie 67 wird nun mittels des Masken-Belichters 81 belichtet, der wiederum wie der Masken-Belichter 81 nach Fig. 2 ausgestaltet ist. Nach der Belichtung mittels des Masken-Belichters 81 ergibt sich damit eine Folie 68, die aus der Grundfolie 61, einer musterförmig strukturiert ausgehärteten Kleberschicht, der elektrischen Funktionsschicht 47, der Ablöseschicht 46 und der Trägerfolie 45 besteht.

Im Gegensatz zu dem Ausführungsbeispiel nach Fig. 2 wird hier ein UV-vernetzbarer Kleber verwendet, dessen Adhäsionskraft gegenüber der elektrischen Funktionsschicht 47 oder gegenüber der Grundfolie 61 geringer ist, als die Adhäsionskraft zwischen der elektrischen Funktionsschicht 47 und der Trägerfolie 45. Natürlich ist es auch möglich, denselben Kleber wie nach Fig. 1 oder Fig. 2 zu verwenden und durch die Wahl der Materialien der Trägerfolie 45, des Grundkörpers 61 oder der Ablöseschicht 46 eine entsprechende Verteilung der Adhäsionskräfte herbeizuführen.

Wird so die Trägerfolie 45 von dem restlichen Folienkörper der Folie 68 abgezogen, so verbleibt in den Bereichen, in denen die Kleberschicht ausgehärtet ist und damit die elektrische Funktionsschicht 47 mit der Grundfolie 61 verklebt, die elektrische Funktionsschicht 47 auf dem Grundkörper 61. In den übrigen Bereichen sind die Adhäsionskräfte, die ein Ablösen der elektrischen Funktionsschicht 47 von der Trägerfolie 45 verhindern, grösser als die Adhäsionskräfte zwischen der elektrischen Funktionsschicht 47 und der Grundfolie 61, so dass die elektrische Funktionsschicht 47 in diesen Bereichen nicht von der Trägerfolie 45 abgelöst wird.

Damit ergibt sich eine Folie 69, die eine musterförmig strukturierte elektrische Funktionsschicht 47 aufweist, die über eine entsprechend musterförmig strukturierte ausgehärtete Kleberschicht mit der Grundfolie 61 verbunden ist.

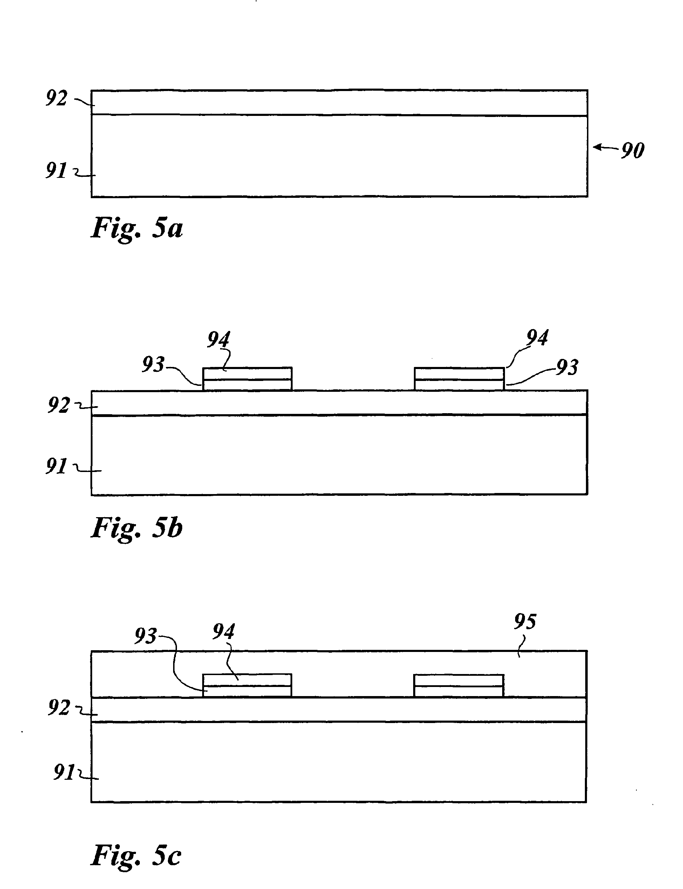

Anhand der Figuren Fig. 5a bis Fig. 5e wird nun beispielhaft erläutert, wie mittels eines der Verfahren nach Fig. 1, Fig. 2 oder Fig. 3 ein Feldeffekt-Transistor in organischer Halbleiter-Technologie gefertigt werden kann.

Fig. 5a zeigt eine Grundfolie 90, die aus einer Trägerfolie 91 und einer darauf aufgebrachten Lackschicht 92 besteht.

Bei der Trägerfolie 91 handelt es sich um eine Kunststoff-Folie, vorzugsweise um eine Polyester-Folie einer Stärke von 19 µm bis 38 µm. Bei der Lackschicht 92 handelt es sich um eine Lackschicht aus einem elektrisch isolierenden Material, die zusätzlich als Schutzlackschicht wirkt. Diese Lackschicht wird vorzugsweise in einer Schichtdicke von 0,5 bis 5 µm auf die Trägerfolie 91 oder auf eine zwischen der Trägerfolie 91 und der Lackschicht 92 liegende Ablöseschicht aufgebracht.

Auf die Grundfolie 90 wird nun, wie in Fig. 5b gezeigt, mittels eines der Verfahren nach Fig. 1, Fig. 2 oder Fig. 3 eine elektrische Funktionsschicht 94 aufgebracht. Damit ergibt sich der in Fig. 5b gezeigte Folienkörper, der aus der Trägerfolie 91, der Lackschicht 92, einer Kleberschicht 93 und einer elektrischen Funktionsschicht 94 besteht. Die elektrische Funktionsschicht 94 besteht hierbei aus einem elektrisch leitfähigen Material und erbringt innerhalb des elektrischen Bauelements die Funktion einer Drain- und einer Source-Elektrode. Je nach Art der verwendeten Verfahren ist es hierbei möglich, dass die Kleberschicht 93, wie in Fig. 5b gezeigt, in gleicher Weise musterförmig strukturiert ist wie die elektrische Funktionsschicht 94, oder dass sie vollflächig auf der Lackschicht 92 in ausgehärteter Form vorliegt.

Anschliessend wird auf den Folienkörper nach Fig. 5b eine halbleitende Schicht aufgebracht, so dass sich der in Fig. 5c gezeigte Folienkörper, bestehend aus der Trägerfolie 91, der Lackschicht 92, der Kleberschicht 93, der elektrischen Funktionsschicht 94 und der halbleitenden Schicht 95, ergibt. Als Material für die halbleitende Schicht 95 wird hier Polythiophen verwendet, das in flüssiger, gelöster Form oder als Suspension auf den Folienkörper nach Fig. 5b aufgebracht und dann verfestigt wird. Auch ein musterförmig strukturierter Auftrag der halbleitenden Schicht 95 ist möglich.

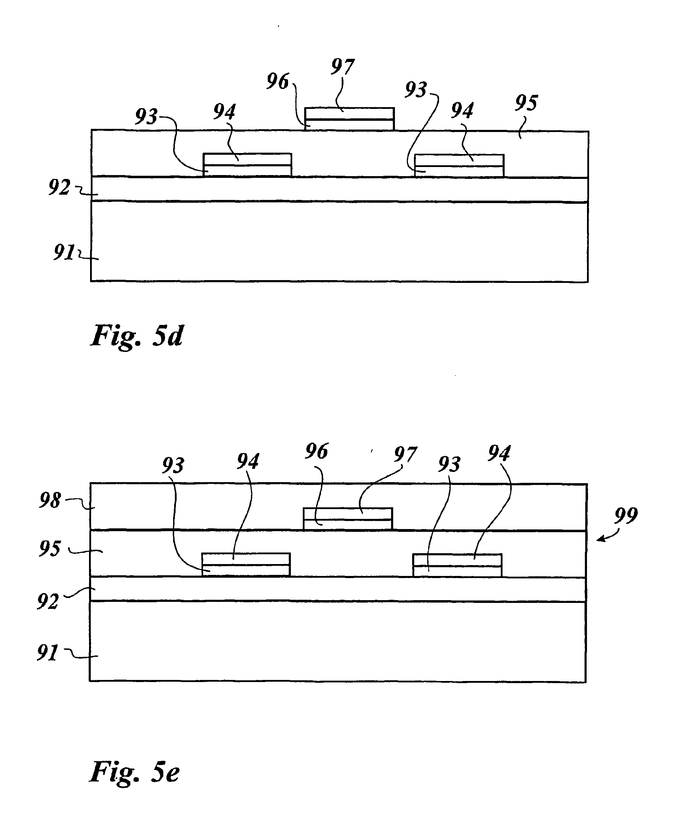

Der Folienkörper nach Fig. 5c bildet nun eine Grundfolie, auf die mittels eines der Verfahren nach Fig. 1, Fig. 2 oder Fig. 3 eine elektrische Funktionsschicht 97 aufgebracht wird. Fig. 5d zeigt den sich hierdurch ergebenden Folienkörper, der aus der Trägerfolie 91, der Lackschicht 92, der Kleberschicht 93, der elektrischen Funktionsschicht 94, der halbleitenden Schicht 95, der Kleberschicht 96 und der elektrischen Funktionsschicht 97 besteht.

Die elektrische Funktionsschicht 97 besteht hier ebenfalls aus einem elektrisch leitfähigen Material und wirkt innerhalb des elektrischen Bauelements als Gate-Elektrode. Die Kleberschicht 96 ist musterförmig strukturiert wie die darüber liegende elektrische Funktionsschicht 97 ausgeformt. Bei Verwendung der Verfahren nach Fig. 2 oder Fig. 3 ist es aber auch möglich, dass die Kleberschicht 96 vollflächig auf der halbleitenden Schicht 95 aufgebracht ist.

In einem weiteren Verfahrensschritt wird nun auf den in Fig. 5d gezeigten Folienkörper eine weitere Lackschicht 98 aus einem elektrisch isolierenden Material aufgebracht, die im weiteren auch die Funktion einer Schutzschicht für die halbleitende Schicht 95 übernimmt. Wie in Fig. 5e gezeigt, ergibt sich somit eine Folie 99, die aus der Trägerfolie 91, den Lackschichten 92 und 98, der halbleitenden Schicht 95, den Kleberschichten 93 und 96 und den elektrischen Funktionsschichten 94 und 97 besteht.

## Patentansprüche

1. Verfahren zur Herstellung einer Folie (55, 66, 69, 99) mit zumindest einem elektrischen Bauelement, insbesondere in organischer Halbleiter-Technologie,
wobei auf eine Grundfolie (51, 61, 90) eine Kleberschicht (57, 93, 96) aus einem Strahlungs-vernetzbaren Kleber aufgebracht wird, dass die Kleberschicht (57, 93, 96) aus dem Strahlungs-vernetzbaren Kleber in musterförmig strukturierter Form auf die Grundfolie (51) aufgebracht wird und/oder derart musterförmig bestrahlt wird, dass die Kleberschicht musterförmig strukturiert aushärtet, dass eine Transferfolie (41), die eine Trägerfolie (45) und eine elektrische Funktionsschicht (47, 94, 97) aufweist, mit einer Orientierung der elektrischen Funktionsschicht (47, 94, 97) zur Kleberschicht (57, 93, 96) auf die Kleberschicht (57, 93, 96) aufgebracht wird, und dass die Trägerfolie (45) von dem die Grundfolie (51), die Kleberschicht (57, 93, 96) und die elektrische Funktionsschicht (47, 94, 97) umfassenden Folienkörper (54, 64, 68) abgezogen wird, wobei in einem ersten musterförmig strukturierten Bereich die elektrische Funktionsschicht (47, 94, 97) als Teil des elektrischen Bauelements auf der Kleberschicht (57, 93, 96) und der Grundfolie (51, 61, 90) verbleibt und in einem zweiten musterförmig strukturierten Bereich die elektrische Funktionsschicht (47, 94, 97) auf der Trägerfolie (45) verbleibt und mit der Trägerfolie von der Grundfolie (51, 61, 90) abgezogen wird, wobei die Kleberschicht aus dem Strahlungs-verrietzbaren Kleber nach dem Aufbringen der Transferfolie (41) musterförmig bestrahlt wird, wodurch die Kleberschicht in einem musterförmig strukturierten Bereich aushärtet, und dass die Trägerfolie von dem die Grundfolie (51), die Kleberschicht und die elektrische Funktionsschicht umfassenden Folienkörper (68) abgezogen wird, so dass die elektrische Funktionsschicht in dem musterförmig strukturierten ersten Bereich, in dem die Kleberschicht ausgehärtet ist, auf der Grundfolie (51) verbleibt, und in dem zweiten Bereich, in dem die Kleberschicht nicht ausgehärtet ist, mit der Trägerfolie (45) abgezogen wird.

2. Verfahren zur Herstellung einer Folie (55, 66, 69, 99) mit zumindest einem elektrischen Bauelement, insbesondere in organischer Halbleiter-Technologie, wobei auf eine Grundfolie (51, 61, 90) eine Kleberschicht (57, 93, 96) aus einem Strahlungs-vernetzbaren Kleber aufgebracht wird, dass die Kleberschicht (57, 93, 96) aus dem Strahlungs-vernetzbaren Kleber in musterförmig strukturierter Form auf die Grundfolie (51) aufgebracht wird und/oder derart musterförmig bestrahlt wird, dass die Kleberschicht musterförmig strukturiert aushärtet, dass eine Transferfolie (41), die eine Trägerfolie (45) und eine elektrische Funktionsschicht (47, 94, 97) aufweist, mit einer Orientierung der elektrischen Funktionsschicht (47, 94, 97) zur Kleberschicht (57, 93, 96) auf die Kleberschicht (57, 93, 96) aufgebracht wird, und dass die Trägerfolie (45) von dem die Grundfolie (51), die Kleberschicht (57, 93, 96) und die elektrische Funktionsschicht (47, 94, 97) umfassenden Folienkörper (54, 64, 68) abgezogen wird, wobei in einem ersten musterförmig strukturierten Bereich die elektrische Funktionsschicht (47, 94, 97) als Teil des elektrischen Bauelements auf der Kleberschicht (57, 93, 96) und der Grundfolie (51, 61, 90) verbleibt und in einem zweiten musterförmig strukturierten Bereich die elektrische Funktionsschicht (47, 94, 97) auf der Trägerfolie (45) verbleibt und mit der Trägerfolie von der Grundfolie (51, 61, 90) abgezogen wird,
wobei die Kleberschicht aus dem Strahlungs-vernetzbaren Kleber vor dem Aufbringen der Transferfolie (41) derart musterförmig bestrahlt wird, dass die Kleberschicht in einem musterförmig strukturierten Bereich aushärtet, dass die Transferfolie (41) auf die musterförmig strukturiert ausgehärtete Kleberschicht aufgebracht wird, und dass die Trägerfolie (45) von dem die Grundfolie (61), die Kleberschicht und die elektrische Funktionsschicht (47) umfassenden Folienkörper (64) abgezogen wird, so dass die elektrische Funktionsschicht (47) in dem musterförmig strukturierten ersten Bereich, in dem die Kleberschicht nicht ausgehärtet ist, auf der Grundfolie (61) verbleibt und in dem musterförmig strukturierten zweiten Bereich, in dem die Kleberschicht ausgehärtet ist, mit der Trägerfolie (45) abgezogen wird.

3. Verfahren nach Anspruch 1 oder 2,
**dadurch gekennzeichnet,**
**dass** die Kleberschicht (47) aus dem Strahlungs-vernetzbaren Kleber auf die Grundfolie (51) mittels eines Druckverfahrens musterförmig strukturiert aufgebracht wird.

4. Verfahren nach einem der Ansprüche 1 bis 3,
**dadurch gekennzeichnet,**
**dass** die Kleberschicht mittels Tiefdruck auf die Grundfolie (51) aufgedruckt wird.

5. Verfahren nach einem der vorhergehenden Ansprüche,
**dadurch gekennzeichnet,**
**dass** die Kleberschicht (57) mittels Offset-Druck oder Flexo-Druck auf die Grundfolie (51) aufgedruckt wird.

6. Verfahren nach einem der Ansprüche 3 bis 5,
**dadurch gekennzeichnet,**
**dass** die Transferfolie (41) Strahlungs-transparent ist und dass die Kleberschicht (57) von Seiten der Transferfolie (41) durch die Transferfolie (41) belichtet wird.

7. Verfahren nach einem der Ansprüche 3 bis 5,
**dadurch gekennzeichnet,**
**dass** die Grundfolie Strahlungs-transparent ist und die Kleberschicht von Seiten der Grundfolie durch die Grundfolie belichtet wird.

8. Verfahren nach einem der Ansprüche 1 bis 7,
**dadurch gekennzeichnet,**
**dass** ein Strahlungs-vernetzbarer Kleber verwendet wird, der im nicht ausgehärteten Zustand eine geringere Adhäsionskraft gegenüber der elektrischen Funktionsschicht als die Adhäsionskraft zwischen der elektrischen Funktionsschicht und der Trägerfolie besitzt.

9. Verfahren nach Anspruch 2,
**dadurch gekennzeichnet,**
**dass** die Kleberschicht anschliessend in einem zweiten Belichtungsschritt zur Aushärtung der noch nicht ausgehärteten Bereiche der Kleberschicht bestrahlt wird.

10. Verfahren nach einem der Ansprüche 1 bis 9,
**dadurch gekennzeichnet,**
**dass** zur Belichtung ein Maskenbelichter, insbesondere ein Trommelbelichter oder ein Maskenbelichter (81) mit einem Maskenband (83) verwendet wird.

11. Verfahren nach einem der vorhergehenden Ansprüche,
**dadurch gekennzeichnet,**
**dass** eine Transferfolie (41) verwendet wird, die eine Ablöseschicht (46) zwischen Trägerfolie (45) und elektrischer Funktionsschicht (47) ausweist.

12. Verfahren nach einem der vorhergehenden Ansprüche,
**dadurch gekennzeichnet,**
**dass** die elektrische Funktionsschicht (47, 94, 97) eine elektrisch leitfähige Schicht ist.

13. Verfahren nach Anspruch 12,
**dadurch gekennzeichnet,**
**dass** die elektrische Funktionsschicht leitfähige Nano-Partikel, insbesondere Metall-, Russ- oder Graphit-Partikel, enthält.

14. Verfahren nach Anspruch 13,
**dadurch gekennzeichnet,**
**dass** die elektrische Funktiohsschicht aus leitfähigen Nano-Partikeln und Bindemittel besteht.

15. Verfahren nach Anspruch 13 oder Anspruch 14,
**dadurch gekennzeichnet,**
**dass** die elektrische Funktionsschicht beim Aufbringen auf die Grundfolie komprimiert wird, wodurch die elektrische Leitfähigkeit der Funktiorisschicht erhöht wird.

16. Verfahren nach Anspruch 12,
**dadurch gekennzeichnet,**
**dass** die elektrische Funktionsschicht leitfähige Polymere enthält.

17. Verfahren nach Anspruch 12,
**dadurch gekennzeichet,**
**dass** die elektrische Funktionsschicht anorganische Substanzen, beispielsweise ITO-Material, enthält.

18. Verfahren nach Anspruch 12,
**dadurch gekennzeichnet,**
**dass** die elektrische Funktionsschicht eine Metallschicht oder eine Schicht aus einer Metall-Legierung ist.

19. Verfahren nach einem der Ansprüche 1 bis 11,
**dadurch gekennzeichnet,**
**dass** die elektrische Funktionsschicht eine elektrisch halbleitende Schicht ist, die insbesondere halbleitende Polymere aufweist.

20. Verfahren nach einem der vorhergehenden Ansprüche,
**dadurch gekennzeichnet,**
**dass** die Kleberschicht aus einem elektrisch nicht leitfähigen Kleber besteht.

21. Verfahren nach einem der Ansprüche 1 bis 19,
**dadurch gekennzeichnet,**
**dass** die Kleberschicht aus einem elektrisch leitfähigen Kleber besteht.

22. Verfahren nach Anspruch 12,
**dadurch gekennzeichnet,**
**dass** die elektrische Funktionsschicht (94, 97) als eine mikrostrukturierte Elektrodenschicht ausgebildet wird, die eine oder mehrere Elektroden des elektrischen Bauelements bereitstellt.

23. Verfahren nach Anspruch 19,
**dadurch gekenntzeichnet,**
**dass** die elektrische Funktionsschicht als eine mikrostrukturierte Halbleiterschicht ausgebildet wird, die ein oder mehrere halbleitende Komponenten des elektrischen Bauelements bereitstellt.

24. Verfahren nach einem der Ansprüche 1 bis 23,
**dadurch gekennzeichnet,**
**dass** als elektrisches Bauelement ein organischer Feldeffekt-Transistor ausgebildet wird.

## Claims

1. Method for fabricating a film (55, 66, 69, 99) having at least one electric device, in particular in organic semiconductor technology, wherein an adhesive layer (57, 93, 96) of a radiation-crosslinkable adhesive is applied onto a base film (51, 61, 90), wherein the adhesive layer (57, 93, 96) of the radiation-crosslinkable adhesive is applied onto the base film (51) so as to be structured in the form of a pattern and/or is irradiated in the form of a pattern such that the adhesive layer cures so as to be structured in the form of a pattern, wherein a transfer film (41) having a carrier film (45) and an electric functional layer (47, 94, 97) is applied onto the adhesive layer (57, 93, 96) with the electric functional layer (47, 94, 97) being orientated with respect to the adhesive layer (57, 93, 96), and wherein the carrier film (45) is peeled off the film body (54, 64, 68) comprising the base film (51), the adhesive layer (57, 93, 96) and the electric functional layer (47, 94, 97), wherein the electric functional layer (47, 94, 97) remains in a first region, which is structured in the form of a pattern, and forms part of the electric device on the adhesive layer (57, 93, 96) and on the base film (51, 61, 90) and the electric functional layer (47, 94, 97) remains in a second region, which is structured in the form of a pattern, on the carrier film (45) and is peeled off the base film (51, 61, 90) together with the carrier film, wherein the adhesive layer of the radiation-crosslinkable adhesive is irradiated in the form of a pattern after the transfer film (41) has been applied, as a result of which the adhesive layer cures in a region, which is structured in the form of a pattern, and wherein the carrier film is peeled off the film body (68) comprising the base film (51), the adhesive layer and the electric functional layer such that the electric functional layer remains on the base film (51) in the first region, which is structured in the form of a pattern and in which the adhesive layer is cured, and is peeled off together with the carrier film (45) in the second region, in which the adhesive layer is not cured.

2. Method for fabricating a film (55, 66, 69, 99) having at least one electric device, in particular in organic semiconductor technology, wherein an adhesive layer (57, 93, 96) of a radiation-crosslinkable adhesive is applied onto a base film (51, 61, 90), wherein the adhesive layer (57, 93, 96) of the radiation-crosslinkable adhesive is applied onto the base film (51) so as to be structured in the form of a pattern and/or is irradiated in the form of a pattern such that the adhesive layer cures so as to be structured in the form of a pattern, wherein a transfer film (41) having a carrier film (45) and an electric functional layer (47, 94, 97) is applied onto the adhesive layer (57, 93, 96) with the electric functional layer (47, 94, 97) being orientated with respect to the adhesive layer (57, 93, 96), and wherein the carrier film (45) is peeled off the film body (54, 64, 68) comprising the base film (51), the adhesive layer (57, 93, 96) and the electric functional layer (47, 94, 97), wherein the electric functional layer (47, 94, 97) remains in a first region, which is structured in the form of a pattern, and forms part of the electric device on the adhesive layer (57, 93, 96) and on the base film (51, 61, 90) and the electric functional layer (47, 94, 97) remains in a second region, which is structured in the form of a pattern, on the carrier film (45) and is peeled off the base film (51, 61, 90) together with the carrier film, wherein the adhesive layer of the radiation-crosslinkable adhesive is irradiated in the form of a pattern before the transfer film (41) has been applied, such that the adhesive layer cures in a region, which is structured in the form of a pattern, wherein the transfer film (41) is applied onto the adhesive layer, which has cured so as to be structured in the form of a pattern, and wherein the carrier film (45) is peeled off the film body (64) comprising the base film (61), the adhesive layer and the electric functional layer (47) such that the electric functional layer (47) remains on the base film (61) in the first region, which is structured in the form of a pattern and in which the adhesive layer is not cured, and is peeled off together with the carrier film (45) in the second region, which is structured in the form of a pattern and in which the adhesive layer is cured.

3. Method according to Claim 1 or 2, **characterized in that** the adhesive layer (47) of the radiation-crosslinkable adhesive is applied onto the base film (51) so as to be structured in the form of a pattern by means of a printing method.

4. Method according to one of Claims 1 to 3,
**characterized in that** the adhesive layer is printed onto the base film (51) by means of gravure printing.

5. Method according to one of the preceding claims, **characterized in that** the adhesive layer (57) is printed onto the base film (51) by means of offset printing or flexographic printing.

6. Method according to one of Claims 3 to 5,
**characterized in that** the transfer film (41) is radiation-transparent and **in that** the adhesive layer (57) is exposed to light from the transfer film (41) through the transfer film (41).

7. Method according to one of Claims 3 to 5,
**characterized in that** the base film is radiation-transparent and the adhesive layer is exposed to light from the base film through the base film.

8. Method according to one of Claims 1 to 7,
**characterized in that** a radiation-crosslinkable adhesive is used, which has, in the non-cured state, a lower adhesive force with respect to the electric functional layer than the adhesive force between the electric functional layer and the carrier film.

9. Method according to Claim 2, **characterized in that** the adhesive layer is subsequently irradiated in a second light-exposure step in order to cure the as yet uncured regions of the adhesive layer.

10. Method according to one of Claims 1 to 9,
**characterized in that** a mask light-exposure means, in particular a drum light-exposure means, or a mask light-exposure means (81) with a masking tape (83) is used for the purposes of light exposure.

11. Method according to one of the preceding claims, **characterized in that** a transfer film (41) is used which has a release layer (46) between the carrier film (45) and the electric functional layer (47).

12. Method according to one of the preceding claims, **characterized in that** the electric functional layer (47, 94, 97) is an electrically conductive layer.

13. Method according to Claim 12, **characterized in that** the electric functional layer contains conductive nanoparticles, in particular metal, carbon black or graphite particles.

14. Method according to Claim 13, **characterized in that** the electric functional layer consists of conductive nanoparticles and binders.

15. Method according to Claim 13 or 14, **characterized in that** the electric functional layer is compressed when it is applied onto the base film, as a result of which the electric conductivity of the functional layer increases.

16. Method according to Claim 12, **characterized in that** the electric functional layer contains conductive polymers.

17. Method according to Claim 12, **characterized in that** the electric functional layer contains inorganic substances, such as ITO material.

18. Method according to Claim 12, **characterized in that** the electric functional layer is a metal layer or a layer of a metal alloy.

19. Method according to one of Claims 1 to 11,
**characterized in that** the electric functional layer is an electrically semiconducting layer having in particular semiconducting polymers.

20. Method according to one of the preceding claims, **characterized in that** the adhesive layer consists of an electrically non-conductive adhesive.

21. Method according to one of Claims 1 to 19,
**characterized in that** the adhesive layer consists of an electrically conductive adhesive.

22. Method according to Claim 12, **characterized in that** the electric functional layer (94, 97) is configured as a microstructured electrode layer which provides one or more electrodes of the electric device.

23. Method according to Claim 19, **characterized in that** the electric functional layer is configured as a microstructured semiconductor layer which provides one or more semiconducting components of the electric device.

24. Method according to one of Claims 1 to 23,
**characterized in that** an organic field-effect transistor is configured as an electric device.

## Revendications

1. Procédé de fabrication d'une feuille (55, 66, 69, 99) avec au moins un composant électrique, en particulier en technologie des semi-conducteurs organiques, dans lequel sur une feuille de base (51, 61, 90) une couche adhésive (57, 93, 96) composée d'un adhésif réticulable par rayonnement est appliquée, la couche adhésive (57, 93, 96) composée de l'adhésif réticulable par rayonnement est appliquée sous une forme structurée selon un motif sur la feuille de base (51) et/ou est irradiée selon un motif de telle sorte que la couche adhésive durcit de façon structurée selon un motif, qu'une feuille de transfert (41) présentant une feuille de support (45) et une couche fonctionnelle électrique (47, 94, 97), avec une orientation de la couche fonctionnelle électrique (47, 94, 97) vers la couche adhésive (57, 93, 96), est appliquée sur la couche adhésive (57, 93, 96), et que la feuille de support (45) est détachée du corps de feuilles (54, 64, 68) comprenant la feuille de base (51), la couche adhésive (57, 93, 96) et la couche fonctionnelle électrique (47, 94, 97), dans lequel, dans une première zone structurée selon un motif, la couche fonctionnelle électrique (47, 94, 97) en tant que partie du composant électrique reste sur la couche adhésive (57, 93, 96) et la feuille de base (51, 61, 90), et dans une deuxième zone structurée selon un motif, la couche fonctionnelle électrique (47, 94, 97) reste sur la feuille de support (45) et est détachée avec la feuille de support de la feuille de base (51, 61, 90), dans lequel la couche adhésive composée de l'adhésif réticulable par rayonnement est irradiée selon un motif après l'application de la feuille de transfert (41), de manière à ce que la couche adhésive durcisse dans une zone structurée selon un motif, et la feuille de support est détachée du corps de feuilles (68) comprenant la feuille de base (51), la couche adhésive et la couche fonctionnelle électrique, de sorte que la couche fonctionnelle électrique reste sur la feuille de base (51) dans la première zone structurée selon un motif où la couche adhésive a durci, et est détachée avec la feuille de support (45) dans la deuxième zone où la couche adhésive n'a pas durci.

2. Procédé de fabrication d'une feuille (55, 66, 69, 99) avec au moins un composant électrique, en particulier en technologie des semi-conducteurs organiques, dans lequel sur une feuille de base (51, 61, 90) une couche adhésive (57, 93, 96) composée d'un adhésif réticulable par rayonnement est appliquée, la couche adhésive (57, 93, 96) composée de l'adhésif réticulable par rayonnement est appliquée sous une forme structurée selon un motif sur la feuille de base (51) et/ou est irradiée selon un motif de telle sorte que la couche adhésive durcit de façon structurée selon un motif, qu'une feuille de transfert (41) présentant une feuille de support (45) et une couche fonctionnelle électrique (47, 94, 97), avec une orientation de la couche fonctionnelle électrique (47, 94, 97) vers la couche adhésive (57, 93, 96), est appliquée sur la couche adhésive (57, 93, 96), et que la feuille de support (45) et détachée du corps de feuilles (54, 64, 68) comprenant la feuille de base (51), la couche adhésive (57, 93, 96) et la couche fonctionnelle électrique (47, 94, 97), dans lequel dans une première zone structurée selon un motif, la couche fonctionnelle électrique (47, 94, 97) en tant que partie du composant électrique reste sur la couche adhésive (57, 93, 96) et la feuille de base (51, 61, 90), et dans une deuxième zone structurée selon un motif, la couche fonctionnelle électrique (47, 94, 97) reste sur la feuille de support (45) et est détachée avec la feuille de support de la feuille de base (51, 61, 90),
dans lequel la couche adhésive composée de l'adhésif réticulable par rayonnement est irradiée avant l'application de la feuille de transfert (41) selon un motif de telle sorte que la couche adhésive durcit dans une zone structurée selon un motif, que la feuille de transfert (41) est appliquée sur la couche adhésive ayant durci de façon structurée selon un motif, et que la feuille de support (45) est détachée du corps de feuilles (64) comprenant la feuille de base (61), la couche adhésive et la couche fonctionnelle électrique (47), de sorte que la couche fonctionnelle électrique (47) reste sur la feuille de base (61) dans la première zone structurée selon un motif où la couche adhésive n'a pas durci, et est détachée avec la feuille de support (45) dans la deuxième zone structurée selon un motif où la couche adhésive a durci.

3. Procédé selon la revendication 1 ou 2,
**caractérisé en ce**
**que** la couche adhésive (47) composée de l'adhésif réticulable par rayonnement est appliquée sur la feuille de base (51) au moyen d'un procédé d'impression de façon structurée selon un motif.

4. Procédé selon l'une quelconque des revendications 1 à 3,
**caractérisé en ce**
**que** la couche adhésive est imprimée au moyen d'une héliogravure sur la feuille de base (51).

5. Procédé selon l'une quelconque des revendications précédentes,
**caractérisé en ce**
**que** la couche adhésive (57) est imprimée au moyen d'une impression offset ou d'une impression flexographique sur la feuille de base (51).

6. Procédé selon l'une quelconque des revendications 3 à 5,
**caractérisé en ce**
**que** la feuille de transfert (41) est transparente au rayonnement et en ce que la couche adhésive (57) est exposée du côté de la feuille de transfert (41) à travers la feuille de transfert (41).

7. Procédé selon l'une quelconque des revendications 3 à 5,
**caractérisé en ce**
**que** la feuille de base est transparente au rayonnement et la couche adhésive est exposée du côté de la feuille de base à travers la feuille de base.

8. Procédé selon l'une quelconque des revendications 1 à 7,
**caractérisé en ce**
**qu'**un adhésif réticulable par rayonnement est utilisé qui possède à l'état non durci une force d'adhésion par rapport à la couche fonctionnelle électrique inférieure à la force d'adhésion entre la couche fonctionnelle électrique et la feuille de support.

9. Procédé selon la revendication 2,
**caractérisé en ce**
**que** la couche adhésive est ensuite irradiée dans une deuxième étape d'exposition en vue de durcir les zones non encore durcies de la couche adhésive.

10. Procédé selon l'une quelconque des revendications 1 à 9,
**caractérisé en ce**
**que** pour l'exposition, un imageur à masque, en particulier un imageur à tambour ou imageur à masque (81) avec une bande de masquage (83), est utilisé.

11. Procédé selon l'une quelconque des revendications précédentes,
**caractérisé en ce**
**qu'**une feuille de transfert (41) est utilisée qui présente une couche de détachement (46) entre la feuille de support (45) et la couche fonctionnelle électrique (47).

12. Procédé selon l'une quelconque des revendications précédentes,
**caractérisé en ce**
**que** la couche fonctionnelle électrique (47, 94, 97) est une couche électriquement conductrice.

13. Procédé selon la revendication 12,
**caractérisé en ce**
**que** la couche fonctionnelle électrique contient des nanoparticules conductrices, en particulier des particules de métal, de noir de carbone ou de graphite.

14. Procédé selon la revendication 13,
**caractérisé en ce**
**que** la couche fonctionnelle électrique se compose de nanoparticules conductrices et d'un liant.

15. Procédé selon la revendication 13 ou 14,
**caractérisé en ce**
**que** la couche fonctionnelle électrique est comprimée lors de l'application sur la feuille de base, de manière à augmenter la conductibilité électrique de la couche fonctionnelle.

16. Procédé selon la revendication 12,
**caractérisé en ce**
**que** la couche fonctionnelle électrique contient des polymères conducteurs.

17. Procédé selon la revendication 12,
**caractérisé en ce**
**que** la couche fonctionnelle électrique contient des substances anorganiques, par exemple une matière ITO.

18. Procédé selon la revendication 12,
**caractérisé en ce**
**que** la couche fonctionnelle électrique est une couche de métal ou une couche en alliage de métal.

19. Procédé selon l'une quelconque des revendications 1 à 11,
**caractérisé en ce**
**que** la couche fonctionnelle électrique est une couche électriquement semi-conductrice présentant en particulier des polymères semi-conducteurs.

20. Procédé selon l'une quelconque des revendications précédentes,
**caractérisé en ce**
**que** la couche adhésive se compose d'un adhésif électriquement non conducteur.

21. Procédé selon l'une quelconque des revendications 1 à 19,
**caractérisé en ce**
**que** la couche adhésive se compose d'un adhésif électriquement conducteur.

22. Procédé selon la revendication 12,
**caractérisé en ce**
**que** la couche fonctionnelle électrique (94, 97) est réalisée comme une couche d'électrodes micro-structurée fournissant une ou plusieurs électrodes du composant électrique.

23. Procédé selon la revendication 19,
**caractérisé en ce**
**que** la couche fonctionnelle électrique est réalisée comme une couche semi-conductrice micro-structurée fournissant un ou plusieurs composants semi-conducteurs du composant électrique.

24. Procédé selon l'une quelconque des revendications 1 à 23,
**caractérisé en ce**
**qu'**un transistor à effet de champ organique est réalisé comme composant électrique.
